# EUROPÄISCHE PATENTSCHRIFT

(11) **EP 3 660 597 B1**
(45) Veröffentlichungstag und Bekanntmachung des Hinweises auf die Patenterteilung: **08.06.2022**
(21) Anmeldenummer: 19211213.4
(22) Anmeldetag: 25.11.2019
(51) Int. Cl.: G05B 9/02, G05B 19/042

(54) **SCHALTGERÄT ZUM FEHLERSICHEREN EIN- ODER AUSSCHALTEN EINER GEFÄHRLICHEN MASCHINENANLAGE**
SWITCHING DEVICE FOR FAIL SAFE SWITCHING ON AND OFF A DANGEROUS MACHINE SYSTEM
DISPOSITIF POUR UNE COMMUTATION D'UN SYSTÈME DE MACHINE DANGEREUSE

(30) Priorität: 27.11.2018 DE 102018129899
(43) Veröffentlichungstag der Anmeldung: 03.06.2020
(73) Patentinhaber: Pilz GmbH & Co. KG, 73760 Ostfildern (DE)
(72) Erfinder: Heinisch, Sascha, 73760 Ostfildern (DE); Bauknecht, Jochen, 73760 Ostfildern (DE); Häberle, Thomas, 73760 Ostfildern (DE)
(74) Vertreter: Witte, Weller & Partner Patentanwälte mbB

(56) Entgegenhaltungen:
- EP-A1- 2 383 762
- EP-A1- 3 106 942
- DE-A1- 10 016 712
- DE-A1-102014 110 018

## Beschreibung

Die vorliegende Erfindung betrifft ein Schaltgerät zum gezielten Einschalten und/oder Ausschalten eines elektrischen Verbrauchers, insbesondere zum fehlersicheren Abschalten einer gefährlichen Maschinenanlage, mit einem Eingangsteil zum Aufnehmen eines definierten Eingangssignals, mit einem Ausgangsteil, der einen Strompfad mit einem Ausgangsschaltelement zu dem elektrischen Verbraucher aufweist, wobei das Ausgangsschaltelement einen geschlossenen Betriebszustand oder einen geöffneten Betriebszustand annehmen kann, mit einem Steuerteil, der einen ersten aktiven Betriebsmodus besitzt, in dem der Steuerteil das Ausgangsschaltelement in Abhängigkeit von dem definierten Eingangssignal ansteuert, um den Strompfad in Abhängigkeit von dem definierten Eingangssignal zu schließen oder zu unterbrechen, und mit einem Anzeigeelement, das einen ersten Anzeigezustand und einen alternativen zweiten Anzeigezustand annehmen kann. Ein solches Schaltgerät ist aus DE 10 2014 110 018 A1 bekannt.

Schaltgeräte werden in vielen verschiedenen Maschinen und Maschinenanlagen verwendet, um Maschinenfunktionen und/oder Maschinenteile gezielt ein- oder auszuschalten. Besondere Bedeutung haben sogenannte Sicherheitsschaltgeräte, die verwendet werden, um zu gewährleisten, dass eine Maschinenfunktion und/oder ein Maschinenteil nur dann betrieben werden kann, wenn von der Maschinenfunktion oder dem Maschinenteil keine Gefahr für Personen ausgeht. Sicherheitsschaltgeräte müssen diese Sicherheitsfunktion insbesondere auch dann gewährleisten, wenn ein Fehler in der Maschinenanlage oder dem Sicherheitsschaltgerät selbst auftritt, bspw. infolge Bauteilversagens oder Beschädigung eines Verbindungskabels. Daher gelten für Sicherheitsschaltgeräte besondere Anforderungen an die Fehlersicherheit, die in einschlägigen Normen festgelegt sind, wie insbesondere EN 61508, ISO 13849, EN 62061 und anderen. Sicherheitsschaltgeräte sind im Folgenden Schaltgeräte, die zumindest den Performance Level (PL) d und/oder den Sicherheits-Integritätslevel (SIL) 2 gemäß der vorgenannten Normen erfüllen.

DE 100 11 211 A1 offenbart ein Sicherheitsschaltgerät und ein System aus mehreren Sicherheitsschaltgeräten, die in Reihe zueinander angeordnet sind. In einem Ausführungsbeispiel ist ein Not-Aus-Schalter mit zwei Öffnerkontakten an den Eingangsteil angeschlossen. Dem Steuerteil werden über die Öffnerkontakte zwei Eingangssignale zugeführt. Wenn man den Not-Aus-Schalter betätigt, öffnen sich die Kontakte, was in dem Steuerteil erkannt werden kann, weil die Eingangssignale nicht mehr zu dem Eingangsteil gelangen. Zusätzlich überwacht der Steuerteil die Eingangssignale auf Plausibilität. Beispielsweise kann der Steuerteil einen Querschluss, der Folge eines beschädigten Kabels sein kann, erkennen, wenn man die Eingangssignale ungleich wählt. Der Steuerteil steuert in Abhängigkeit von den Eingangssignalen zwei Ausgangsschaltelemente, mit deren Hilfe kann eine Maschine fehlersicher abgeschaltet werden kann.

Maschinen und Maschinenanlagen besitzen häufig eine Vielzahl von Sensoren/Signalgebern, die Eingangssignale liefern. Die Eingangssignale werden logisch miteinander verknüpft, um einen oder mehrere Verbraucher zu schalten. Viele Schaltgeräte erlauben es einem Anwender, die logischen Verknüpfungen individuell festzulegen, sei es mit Hilfe eines Anwenderprogramms, das in einer geeigneten Programmiersprache programmiert wird, sei es durch Konfigurieren vordefinierter Steuerprogramme und/oder durch geeignete Auswahl und Kombination von Schaltgeräten mit jeweils vordefiniertem Funktionsumfang. Die Festlegung der logischen Verknüpfungen zwischen den Eingangssignalen und den Ausgangssignalen zum Schalten eines Verbrauchers kann mit zunehmender Anzahl der Eingangssignale und Verbraucher eine sehr anspruchsvolle Aufgabe sein. Bei Sicherheitsschaltgeräten ist die Festlegung der logischen Verknüpfungen darüber hinaus sicherheitsrelevant. Daher ist es wünschenswert, Fehler in den logischen Verknüpfungen möglichst frühzeitig und zuverlässig zu erkennen.

DE 100 20 074 A1 offenbart ein modulares Sicherheitsschaltgeräte-System mit einer Vielzahl von sogenannten Eingangsmodulen, die jeweils sicherheitsrelevante Signalgeber, wie etwa Not-Aus-Schalter und Schutztürschalter, auswerten, und mit zumindest einem Ausgangsmodul zum fehlersicheren Betätigen eines Aktors. Die Eingangs- und Ausgangsmodule können in verschiedenen Betriebsmodi betrieben werden. Ein gewünschter Betriebsmodus kann an einem Steuermodul mit Hilfe von Tasten eingestellt werden. Der eingestellte Betriebsmodus wird mit Hilfe von LEDs angezeigt. Um zu gewährleisten, dass der tatsächlich eingestellte Betriebsmodus richtig angezeigt wird, werden die LEDs überwacht. Eine fehlerhafte LED kann somit erkannt werden und das System wird ggf. abgeschaltet.

DE 100 20 075 A1 offenbart eine weitere Sicherheitsschaltgeräte-Modulanordnung mit einer Vielzahl von Eingangsmodulen und Ausgangsmodulen, die in einer vom Anwender wählbaren Modulreihe angeordnet werden. Die logische Zuordnung eines Eingangsmoduls zu einem oder mehreren Ausgangsmodulen ist hier von der Position des entsprechenden Eingangsmoduls in der Modulreihe abhängig. Ein Anwender kann die logischen Verknüpfungen zwischen den Eingangssignalen und den Aktoren/Verbrauchern an den Ausgangsmodulen also durch geeignete Auswahl der Modulpositionen der Eingangsmodule innerhalb der Modulreihe festlegen.

DE 101 08 962 A1 offenbart ein Verfahren und eine Vorrichtung zum Programmieren einer Sicherheitssteuerung. Die logischen Verknüpfungen zwischen Eingangssignalen und Ausgangssignalen der Sicherheitssteuerung werden hier anhand von vordefinierten funktionsspezifischen Programmmodulen festgelegt, die aus einer Menge derartiger Programmmodule ausgewählt werden.

Aus einer Betriebsanleitung der Pilz GmbH & Co. KG, Felix-Wankel-Str. 2, 73760 Ostfildern, Deutschland mit dem Titel PNOZ E8.1p und mit der Sachnummer 1002226-EN-06 ist ein Sicherheitsschaltgerät mit zwei sogenannten Sicherheitsausgängen und zwei LEDs bekannt. Die LEDs zeigen den jeweiligen Schaltzustand der Sicherheitsausgänge an. Ein Anwender kann anhand der LEDs daher erkennen, in welchem Betriebszustand die sicherheitsrelevanten Ausgangsschaltelemente des Sicherheitsschaltgerätes sind.

Die oben genannte DE 10 2014 110 018 A1 offenbart ein Sicherheitsschaltgerät, das über DIP-Schalter konfiguriert werden kann. Dazu liest eine erste Steuereinrichtung einen an den DIP-Schaltern eingegebenen Eingangswert ein und übergibt diesen Eingangswert einer zweiten Steuereinrichtung, welche LED-Anzeigeelemente zur Ausgabe einer optischen Information ansteuert. Daher kann eine Bedienperson anhand der LED-Anzeigeelemente erkennen, dass das an den DIP-Schaltern eingestellte Bitmuster korrekt eingelesen worden ist. In einer Speichereinrichtung sind Dateninhalte gespeichert, denen jeweils ein Eingangswert zugeordnet ist. Die erste und/oder zweite Steuereinrichtung kann den Zugriff auf einen Dateninhalt anhand des eingegebenen Bitmusters steuern.

EP 2 383 762 A1 offenbart eine Sicherheitsschaltvorrichtung zum ausfallsicheren Ein- und Ausschalten einer elektrischen Last und ein System, das mindestens zwei Sicherheitsschaltvorrichtungen umfasst, die über einen einzigen Kanal ausfallsicher interagieren. Eine erste Sicherheitsschaltvorrichtung liefert abhängig von einem ersten Schaltsignal ein getaktetes Signal an die zweite Sicherheitsschaltvorrichtung und das getaktete Signal wird zur Durchführung eines Querfehlers überwacht.

DE 100 16 712 A1 offenbart ein Sicherheitsschaltgerät zum sicheren Ein-/Ausschalten eines elektrischen Verbrauchers, mit einem Not-Aus-Schalter, mit einem Ausgangsteil und mit einer Steuereinheit, wobei das Sicherheitsschaltgerät in drei verschiedenen Betriebsmodi betrieben werden kann, wobei die Betriebsarten für verschiedene angeschlossene Sicherheitsgeber ausgebildet sind.

EP 3 106 942 A1 offenbart eine Sicherheitssteuerung zum sicheren Ein-/Ausschalten eines elektrischen Verbrauchers, mit einem Not-Aus-Schalter, mit Ausgangseinheiten, mit einem Steuerteil und mit Anzeigeelementen, wobei die Anzeigeelemente in zwei Anzeigemodi gesteuert werden können und in dem ersten Anzeigemodus die Anzeigemittel die Zustände als punktuelle Leuchtsignale angezeigt werden und in dem zweiten Anzeigemodus die Anzeigemittel die Zustände als lesbaren Text angezeigt werden.

Vor diesem Hintergrund ist es eine Aufgabe der vorliegenden Erfindung, ein Schaltgerät der eingangs genannten Art, insbesondere ein Sicherheitsschaltgerät, anzugeben, das dem Anwender die Festlegung der logischen Verknüpfungen erleichtert und dass dazu beiträgt, insbesondere sicherheitsrelevante Fehler vor Inbetriebnahme einer Maschine oder Maschinenanlage zu erkennen und zu vermeiden.

Gemäß der vorliegenden Erfindung wird diese Aufgabe durch ein Schaltgerät gemäß Anspruch 1 gelöst.

Der Steuerteil des neuen Schaltgerätes besitzt zumindest zwei alternative Betriebsmodi, die jeweils aktiv sind, weil das Schaltgerät in jedem der beiden Betriebsmodi betrieben werden kann. Der erste Betriebsmodus ist der "normale" Betriebsmodus (häufig als RUN bezeichnet), in dem der Steuerteil den Strompfad zu dem elektrischen Verbraucher in Abhängigkeit von dem zumindest einen Eingangssignal öffnet oder schließt.

Der zweite Betriebsmodus ist gewissermaßen ein Simulationsmodus. Einerseits ist der Strompfad zu dem Verbraucher in dem zweiten Betriebsmodus dauerhaft unterbrochen. Der elektrische Verbraucher ist in dem zweiten Betriebsmodus folglich unabhängig von dem definierten Eingangssignal ausgeschaltet. Darin unterscheidet sich der zweite Betriebsmodus von dem ersten Betriebsmodus. Andererseits nimmt das Anzeigeelement in dem zweiten Betriebsmodus aber in Abhängigkeit von dem definierten Eingangssignal den ersten Anzeigezustand oder den alternativen zweiten Anzeigezustand an. Dies bedeutet, dass das Anzeigeelement den jeweils "theoretischen" Betriebszustand des Ausgangsschaltelements simuliert anzeigen kann, ohne dass das Ausgangsschaltelement tatsächlich eingeschaltet wird. Mit anderen Worten sind das Anzeigeelement und das Ausgangsschaltelement in dem ersten Betriebsmodus so miteinander gekoppelt, dass ein Bediener anhand des jeweiligen Anzeigezustands den jeweiligen tatsächlichen Betriebszustand des Ausgangsschaltelements erkennen kann. Der erste Anzeigezustand signalisiert, dass das Ausgangsschaltelement in dem geschlossenen Betriebszustand ist. Der zweite Anzeigezustand signalisiert, dass das Ausgangsschaltelement in dem geöffneten Betriebszustand ist. In einigen Ausführungsbeispielen kann das Anzeigeelement eine LED sein, die in einer ersten Farbe leuchtet, wenn das Ausgangsschaltelement in dem geschlossenen Betriebszustand ist und somit der Strompfad zu dem Verbraucher geschlossen ist. Wenn das Ausgangsschaltelement in dem geöffneten Betriebszustand ist, kann die LED aus sein oder in einer anderen Farbe als beim ersten Anzeigezustand leuchten.

In dem zweiten Betriebsmodus ist die Kopplung zwischen Anzeigeelement und Ausgangsschaltelement aufgehoben. Während das Ausgangsschaltelement dauerhaft in dem geöffneten Betriebszustand ist, kann das Anzeigeelement signalisieren, in welchem Betriebszustand das Ausgangsschaltelement wäre, wenn das Schaltgerät in dem ersten Betriebsmodus wäre.

Die Entkopplung von Anzeigeelement und Ausgangsschaltelement in dem zweiten Betriebsmodus macht es möglich, dass ein Anwender den Betrieb des Schaltgeräts in einer individuellen Anwendung testen kann, ohne dass der elektrische Verbraucher tatsächlich eingeschaltet wird. Der Anwender kann eine individuelle Konfiguration an einer Maschine oder Maschinenanlage testen, ohne die Maschine oder Maschinenanlage in einen gefährlichen Betriebszustand zu bringen. Dementsprechend ermöglicht das neue Schaltgerät einen komfortablen und sicheren Inbetriebnahmetest. Etwaige Fehler in der Konfiguration des Schaltgeräts können in dem zweiten Betriebsmodus anhand des Anzeigeelements erkannt werden, bevor der elektrische Verbraucher tatsächlich mit Hilfe des ersten Betriebsmodus in Betrieb genommen wird. Das neue Schaltgerät erleichtert somit die sichere Inbetriebnahme einer Maschine oder Maschinenanlage. Die oben genannte Aufgabe ist vollständig gelöst.

In einer bevorzugten Ausgestaltung weist der Ausgangsteil einen weiteren Strompfad mit einem weiteren Ausgangsschaltelement auf, das der Steuerteil in dem ersten aktiven Betriebsmodus und in dem zweiten aktiven Betriebsmodus in Abhängigkeit von dem definierten Eingangssignal ansteuert.

In dieser Ausgestaltung besitzt das Schaltgerät zumindest zwei Ausgangsschaltelemente, die zwei separate Strompfade bilden und die jeweils von dem Steuerteil in Abhängigkeit von dem definierten Eingangssignal angesteuert werden. Allerdings wirkt sich ein Wechsel von dem ersten Betriebsmodus in den zweiten Betriebsmodus nur auf das oben beschriebene Ausgangsschaltelement aus. Das weitere Ausgangsschaltelement dieser Ausgestaltung wird sowohl im ersten Betriebsmodus als auch im zweiten Betriebsmodus in Abhängigkeit von dem definierten Eingangssignal geöffnet oder geschlossen. In bevorzugten Ausführungsbeispielen steuert der Steuerteil das erste Ausgangsschaltelement und das weitere Ausgangsschaltelement in dem ersten aktiven Betriebsmodus synchron an, so dass sich das erste Ausgangsschaltelement und das weitere Ausgangsschaltelement weitgehend synchron zueinander öffnen oder schließen. In dem zweiten aktiven Betriebsmodus schalten das erste Ausgangsschaltelement und das weitere Ausgangsschaltelement hingegen nicht mehr synchron. Vielmehr ist das erste Ausgangsschaltelement dauerhaft geöffnet, während das zweite Ausgangsschaltelement in Abhängigkeit von dem definierten Eingangssignal geöffnet oder geschlossen ist. In den bevorzugten Ausführungsbeispielen stellt das weitere Ausgangsschaltelement einen sogenannten Meldeausgang bereit, während das erste Ausgangsschaltelement den elektrischen Verbraucher ein- und/oder ausschaltet. Der Meldeausgang kann im Gegensatz dazu vorteilhaft verwendet werden, um bspw. eine übergeordnete Betriebssteuerung über den jeweiligen Betriebszustand des ersten Ausgangsschaltelements und des daran angeschlossenen Verbrauchers zu informieren. Die Ausgestaltung besitzt den Vorteil, dass der zweite Betriebsmodus (Simulationsmodus) nur den Betriebszustand des ersten Ausgangsschaltelements beeinflusst, wohingegen das weitere Ausgangsschaltelement in dem ersten Betriebsmodus und in dem zweiten Betriebsmodus gleich agiert. Die Ausgestaltung ermöglicht daher einen Test des neuen Schaltgerätes vor Inbetriebnahme des elektrischen Verbrauchers in einer so realitätsnahen Weise wie möglich.

In einer weiteren Ausgestaltung besitzt das neue Schaltgerät einen Betriebsmoduswahleingang zum Zuführen eines Betriebsmoduswahlsignals, mit dem der Steuerteil wahlweise in den ersten oder in den zweiten Betriebsmodus versetzt werden kann.

Diese Ausgestaltung ermöglicht einen einfachen Wechsel zwischen dem ersten Betriebsmodus und dem zweiten Betriebsmodus und erleichtert somit einen Funktionstest des neuen Schaltgeräts unmittelbar während der Inbetriebnahme des elektrischen Verbrauchers. In einigen Ausführungsbeispielen kann der Betriebsmoduswahleingang mit einem Zugangsschutz versehen sein, bspw. in Form eines Schlüsselschalters und/oder mit einer Passwortabfrage. Ein solcher Zugangsschutz macht es möglich, einen Wechsel des Betriebsmodus von einer Autorisierung des Bedieners abhängig zu machen. Da der zweite Betriebsmodus (Simulationsmodus) im Vergleich zu bekannten Schaltgeräten und im Vergleich zu dem ersten Betriebsmodus eine erhöhte Sicherheit bietet, kann ein Zugangsschutz in anderen Ausführungsbeispielen aber entfallen.

In einer weiteren Ausgestaltung steuert der Steuerteil das Anzeigeelement in dem zweiten aktiven Betriebsmodus an. Vorzugsweise steuert der Steuerteil das Anzeigeelement in dieser Ausgestaltung auch in dem ersten aktiven Betriebsmodus an.

In dieser Ausgestaltung kann der Steuerteil den jeweiligen Anzeigezustand des Anzeigeelements "selbst" ändern. Infolgedessen kann der Steuerteil das Anzeigeelement bei einem Wechsel zwischen dem ersten und dem zweiten Betriebsmodus sehr einfach in geeigneter Weise ansteuern, so dass das Anzeigeelement und das erste Ausgangsschaltelement miteinander gekoppelt sind oder nicht. Die Ausgestaltung ermöglicht eine einfache Implementierung und einen einfachen Wechsel zwischen der ersten und zweiten Betriebsart. Die Ausgestaltung ist besonders vorteilhaft, wenn das neue Schaltgerät modular aufgebaut ist und der Ausgangsteil in einem separaten Ausgangsmodul untergebracht ist, weil das Ausgangsmodul in diesem Fall unabhängig von der gewählten Betriebsart des Steuerteils arbeiten kann.

In einer weiteren Ausgestaltung steuert der Ausgangsteil das Anzeigeelement in dem ersten aktiven Betriebsmodus an. In einigen Ausführungsbeispielen kann der Ausgangsteil das Anzeigeelement auch in dem zweiten aktiven Betriebsmodus ansteuern.

In dieser Ausgestaltung ist die Ansteuerung des Anzeigeelements zumindest in dem ersten Betriebsmodus in den Ausgangsteil verlagert. Die Ausgestaltung besitzt den Vorteil, dass der Steuerteil den Ausgangsteil sowohl im ersten Betriebsmodus als auch im zweiten Betriebsmodus in gleicher Weise ansteuern kann. Insbesondere bei einer modularen Implementierung, bei der der Ausgangsteil und der Steuerteil in separaten Modulen untergebracht sind, die bspw. über eine Busverbindung miteinander kommunizieren, kann diese Ausgestaltung dazu beitragen, die Anzahl der Bustelegramme zu minimieren.

In einer weiteren Ausgestaltung besitzt das neue Schaltgerät eine Vielzahl von Gehäusemodulen, die wahlweise aneinandergefügt oder voneinander gelöst werden können, wobei ein erstes Gehäusemodul den Steuerteil beherbergt, und wobei ein zweites Gehäusemodul den Ausgangsteil beherbergt.

In dieser Ausgestaltung besitzt das Schaltgerät einen modularen Aufbau, wobei zumindest der Ausgangsteil und der Steuerteil in separaten Gehäusemodulen angeordnet sind. Die Ausgestaltung ermöglicht eine kostengünstige Skalierung des neuen Schaltgerätes in Bezug auf die Anzahl der Eingänge und Ausgänge. Insbesondere kann ein Schaltgerät diese Ausgestaltung sehr einfach an die Größe einer Maschine oder Maschinenanlage angepasst werden. Neue Maschinenfunktionen können durch Hinzufügen weiterer Module kostengünstig implementiert werden. Je mehr Eingänge und Ausgänge das Schaltgerät besitzt, desto deutlicher kommen die Vorteil zum Tragen.

In einer weiteren Ausgestaltung besitzt das Schaltgerät einen Kommunikationsbus, der den Steuerteil und den Ausgangsteil miteinander verbindet.

In dieser Ausgestaltung tauschen der Steuerteil und der Ausgangsteil Bustelegramme miteinander aus. Die Bustelegramme können Steuerbefehle beinhalten, mit denen das Ausgangsschaltelement von seinem geöffneten Betriebszustand in seinen geschlossenen Betriebszustand gebracht werden kann. In einigen bevorzugten Ausführungsbeispielen informiert der Ausgangsteil den Steuerteil mit Hilfe von Bustelegrammen über den jeweils aktuellen Betriebszustand des Ausgangsschaltelements. Die Ausgestaltung ermöglicht auf sehr kostengünstige Weise eine Realisierung mit vielen Eingängen und Ausgängen.

In einer weiteren Ausgestaltung weist der Ausgangsteil einen Rückleseschaltkreis auf, der ein aktuelles Betriebszustandssignal erzeugt, das für den geöffneten und/oder den geschlossenen Betriebszustand des Ausgangsschaltelements repräsentativ ist, wobei der Steuerteil das Ausgangsschaltelement in Abhängigkeit von dem Betriebszustandssignal ansteuert.

Diese Ausgestaltung besitzt den Vorteil, dass der Steuerteil den jeweils aktuellen Betriebszustand des Ausgangsschaltelements überwachen und mit einer Erwartungshaltung vergleichen kann. Stimmen der aktuelle Betriebszustand und die Erwartungshaltung nicht überein, kann der Steuerteil eine Fehlermeldung erzeugen und/oder sicherstellen, dass der elektrische Verbraucher nicht in Betrieb genommen wird. Im ersten Betriebsmodus entspricht die Erwartungshaltung regelmäßig dem jeweils aktuellen Steuerbefehl. In dem zweiten Betriebsmodus kann die Erwartungshaltung demgegenüber sein, dass das Ausgangsschaltelement in dem geöffneten Betriebszustand ist. Die Ausgestaltung ermöglicht einen "echten" Funktionstest des Ausgangsteils sowohl in dem ersten Betriebsmodus als auch in dem zweiten Betriebsmodus.

In einer weiteren Ausgestaltung besitzt das Schaltgerät einen Maskenspeicher, in dem eine Bitmaske gespeichert ist, die den jeweils aktiven Betriebsmodus repräsentiert, wobei das Ausgangsschaltelement in Abhängigkeit von der Bitmaske gesteuert ist.

Diese Ausgestaltung ermöglicht eine sehr effiziente Implementierung des neuen Schaltgeräts, insbesondere mit einem modularen Aufbau. Die Ausgestaltung besitzt den Vorteil, dass das unterschiedliche Verhalten des Ausgangsteils in dem ersten Betriebsmodus und in dem zweiten Betriebsmodus im Wesentlichen dadurch erreicht werden kann, dass eine jeweils geeignete Bitmaske in den Maskenspeicher geschrieben wird. Buszyklusseiten, Signalverarbeitungszeiten und logisches Verhalten des Steuerteils und des Ausgangsteils können in dieser Ausgestaltung unabhängig von dem jeweils gewählten Betriebsmodus gleich sein. Infolgedessen ermöglicht diese Ausgestaltung einen sehr realitätsnahen Funktionstest des Schaltgeräts vor Inbetriebnahme des elektrischen Verbrauchers.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen.
- Fig. 1: eine schematische Darstellung einer Maschinenanlage mit einem Ausführungsbeispiel des neuen Schaltgerätes,
- Fig. 2: ein Ausführungsbeispiel des Schaltgerätes aus Fig. 1 mit einem modularen Aufbau, und
- Fig. 3: ein Logikdiagramm zur Erläuterung des Schaltgerätes aus Fig. 2.

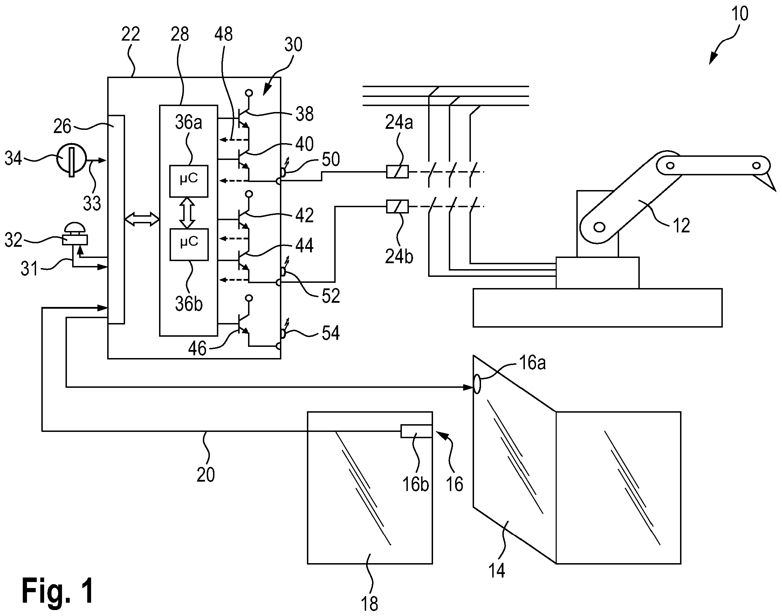

In Fig. 1 ist eine Maschinenanlage mit einem Ausführungsbeispiel des neuen Schaltgerätes insgesamt mit der Bezugsziffer 10 bezeichnet. Die Maschinenanlage 10 beinhaltet hier beispielhaft einen Roboter 12 mit einem gefährlichen Arbeitsbereich, der hier mit einer Schutztür 14 abgesichert wird. An der Schutztür ist ein Schutztürschalter 16 angeordnet. Der Schutztürschalter 16 besitzt ein Türteil 16a an der beweglichen Schutztür 14 und ein Rahmenteil 16b an einem Türrahmen 18, an dem die Schutztür 14 in geschlossenem Zustand anliegt. Das Rahmenteil 16b kann die Anwesenheit des Türteils 16a detektieren und ein Eingangssignal 20 erzeugen, das mit dem Schaltgerät 22 überwacht und ausgewertet wird.

Üblicherweise werden die Arbeitsbewegungen des Roboters 12, allgemeiner der Maschinenanlage 10, mit einer Maschinensteuerung gesteuert (hier aus Gründen der Übersichtlichkeit nicht dargestellt). In einigen Ausführungsbeispielen kann das Schaltgerät 22 in die Maschinensteuerung integriert sein. In anderen Ausführungsbeispielen kann das Schaltgerät 22 getrennt von der Maschinensteuerung realisiert sein. Im letztgenannten Fall kann das Schaltgerät 22 bspw. zwei Schütze 24a, 24b ein- oder ausschalten. Die Schütze 24a, 24b besitzen Arbeitskontakte, die in einem Strompfad zu dem Roboter 12 angeordnet sind. Wenn die Schütze 24a, 24b ausgeschaltet sind, sind die Arbeitskontakte geöffnet, wie dies in Fig. 1 dargestellt ist, und eine Arbeitsbewegung des Roboters 12 ist verhindert.

In dem in Fig. 1 dargestellten Ausführungsbeispiel sind die Schütze 24a, 24b somit elektrische Verbraucher, die mit Hilfe des Schaltgeräts 22 eingeschaltet und/oder ausgeschaltet werden können. Darüber hinaus können weitere Ausführungsbeispiele des neuen Schaltgeräts zum Ein- oder Ausschalten von Magnetventilen, elektrischen Antrieben, Pumpen und jeglichen anderen elektrischen Verbrauchern verwendet werden.

Das Schaltgerät 22 besitzt einen Eingangsteil 26, einen Steuerteil 28 und einen Ausgangsteil 30. Das Eingangssignal 20 von dem Schutztürschalter 16 ist dem Eingangsteil 26 zugeführt. Des Weiteren sind dem Eingangsteil 26 hier beispielhaft ein Eingangssignal 31 von einem Not-Aus-Schalter 32 und ein Eingangssignal 33 von einem Betriebsartenwahlschalter 34 zugeführt.

Der Steuerteil 28 ist in diesem Ausführungsbeispiel zweikanalig-redundant aufgebaut, was hier mit zwei Prozessoren 36a, 36b dargestellt ist. Die Prozessoren 36a, 36b überwachen sich gegenseitig und/oder tauschen ihre Verarbeitungsergebnisse aus. Ein mehrkanalig-redundanter Aufbau wird häufig bei Schaltgeräten verwendet, die zum fehlersicheren Abschalten einer gefährlichen Maschinenanlage verwendet werden. Dementsprechend ist das Schaltgerät 22 in diesem Ausführungsbeispiel ein Sicherheitsschaltgerät oder Teil einer Sicherheitssteuerung, die die Anforderungen für den Performancelevel PL d oder PL e und/oder die Anforderungen gemäß SIL 2 oder SIL 3 im Sinne der eingangs genannten Normen erfüllt. Abweichend von der Darstellung in Fig. 1 kann der Eingangsteil 26 in den Steuerteil 28 integriert sein, indem die Eingangssignale bspw. direkt auf geeignete Eingangsanschlüsse der Prozessoren 36a, 36b geführt sind.

Der Ausgangsteil 30 besitzt in diesem Ausführungsbeispiel fünf Ausgangsschaltelemente 38, 40, 42, 44, 46. Die Schaltelemente 38, 40 sind in Reihe zueinander angeordnet und bilden einen ersten Sicherheitsausgang mit einem Strompfad zu dem Schütz 24a. Die Schaltelemente 42, 44 sind in Reihe zueinander angeordnet und bilden einen zweiten Sicherheitsausgang mit einem Strompfad zu dem Schütz 24b. Der Steuerteil 28 kann die Schütze 24a, 24b aufgrund der jeweils in Reihe angeordneten Schaltelemente 38, 40 und 42, 44 jeweils zweikanalig-redundant ausschalten. Dies ermöglicht ein Ausschalten der Schütze 24a, 24b selbst dann, wenn eines der Schaltelemente 38, 40 und 42, 44 versagt.

Das Schaltelement 46 bilden in diesem Ausführungsbeispiel einen nichtsicheren Meldeausgang. Der Steuerteil 28 kann über den Meldeausgang ein Informationssignal ausgeben. In einigen bevorzugten Ausführungsbeispielen steuert der Steuerteil 28 die Schaltelemente 38 bis 46 weitgehend synchron zueinander an. Das Informationssignal an dem Meldeausgang mit dem Schaltelement 46 kann vorteilhaft verwendet werden, um den jeweiligen Betriebszustand (geöffnet oder geschlossen) der Schaltelemente 38 bis 44 an die Maschinensteuerung für den Roboter 12 und/oder an eine andere übergeordnete Steuerung zu melden.

In Fig. 1 sind die Schaltelemente 38 bis 46 jeweils als bipolare Transistoren dargestellt. Alternativ könnten einige oder alle Schaltelemente 38 bis 46 mit Hilfe von Feldeffekttransistoren, Thyristoren, Relais und anderem realisiert sein. Es versteht sich, dass das Schaltgerät 22 weitere Ausgangsschaltelemente aufweisen kann, weitere Sicherheitsausgänge und/oder weitere Meldeausgänge.

Bei der Bezugsziffer 48 ist in Fig. 1 ein Rückleseschaltkreis angedeutet, mit dessen Hilfe der Steuerteil 28 den jeweiligen Betriebszustand der Schaltelemente 38, 40, 42, 44 einlesen kann. In den bevorzugten Ausführungsbeispielen steuert der Steuerteil 28 die Schaltelemente 38 bis 46 nicht nur in Abhängigkeit von den Eingangssignalen 20, 31, 33 am Eingangsteil 26 an, sondern zusätzlich auch in Abhängigkeit von dem jeweiligen Betriebszustandssignal der Rückleseschaltkreise 48. Insbesondere schaltet der Steuerteil 28 die elektrischen Verbraucher an den Sicherheitsausgängen (hier also die Schütze 24a, 24b) ab, wenn auch nur in einem Fall ein aktueller Betriebszustand der Schaltelemente 38 bis 44 nicht dem vom Steuerteil 28 jeweils eingestellten Betriebszustand entspricht. Dies könnte bspw. auftreten, wenn ein Transistor durchlegiert oder ein Relaiskontakt verschweißt und das entsprechende Schaltelement daher dauerhaft in dem geschlossenen Betriebszustand ist.

In den bevorzugten Ausführungsbeispielen besitzt das Schaltgerät 22 eine Vielzahl von Anzeigeelementen, die den jeweiligen Betriebszustand der Ausgangsschaltelemente anzeigen können. Beispielhaft sind in Fig. 1 eine erste LED 50, eine zweite LED 52 und eine dritte LED 54 dargestellt. Die erste LED 50 zeigt den Betriebszustand der Schaltelemente 38, 40 am ersten Sicherheitsausgang 50 an. Die zweite LED 52 zeigt den Betriebszustand der Schaltelemente 42, 44 an dem zweiten Sicherheitsausgang an. Die dritte LED 54 zeigt den Betriebszustand des Schaltelements 46 an dem Meldeausgang an. In bevorzugten Ausführungsbeispielen ist jedem Sicherheitsausgang ein geeignetes Anzeigeelement, bspw. eine LED, zugeordnet. Bevorzugt ist auch jedem Meldeausgang ein Anzeigeelement zugeordnet. Die Anzeigeelemente 50, 52, 54 besitzen jeweils einen ersten Anzeigezustand und zumindest einen zweiten Anzeigezustand, die verschieden voneinander sind. Der erste Anzeigezustand signalisiert, wenn sich das zugeordnete Schaltelement (oder die Reihe der zugeordneten Schaltelemente) in einem ersten Betriebszustand befindet. Der zweite Anzeigezustand signalisiert, wenn sich das zugeordnete Schaltelement oder die Reihe der zugeordneten Schaltelemente in dem zweiten Betriebszustand befindet. Beispielsweise sind die LEDs 50, 52, 54 eingeschaltet und leuchten, wenn die jeweils zugeordneten Schaltelemente in dem geschlossenen Betriebszustand sind, und die LEDs 50, 52, 54 sind ausgeschaltet, wenn sich die jeweils zugeordneten Schaltelemente in dem geöffneten Zustand befinden. In weiteren Ausführungsbeispielen könnten die Anzeigeelemente zwei verschiedene aktive Anzeigezustände besitzen, um die Betriebszustände der Schaltelemente zu signalisieren, etwa unterschiedliche Farben. Des Weiteren könnten die Anzeigeelemente 50, 52, 54 in weiteren Ausführungsbeispielen mit Hilfe von Graphikdisplays oder mit anderen Arten von Anzeigeelementen realisiert sein, etwa mechanische Anzeigeelemente.

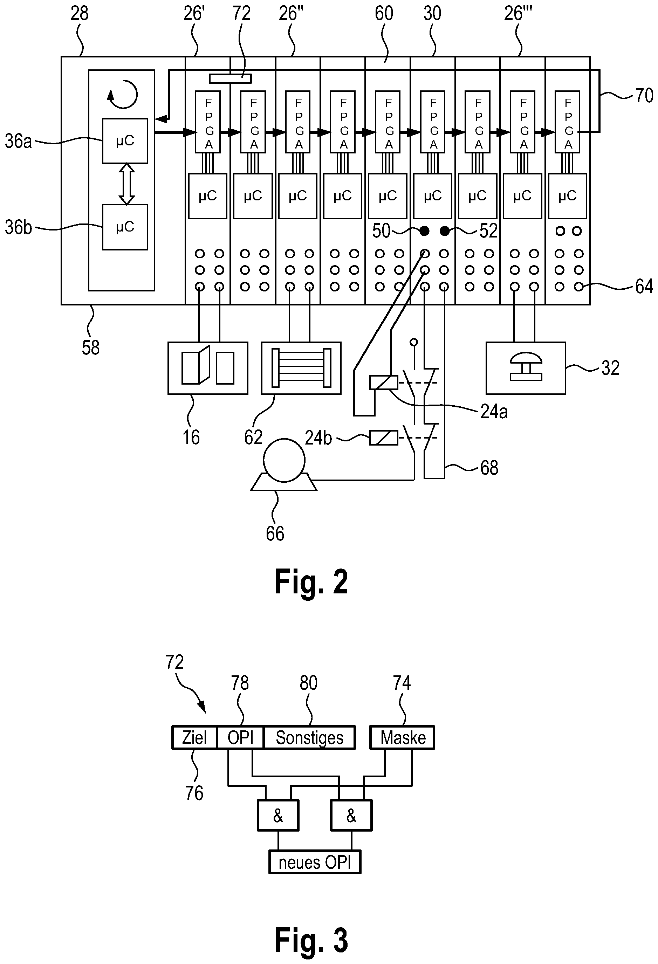

Fig. 2 zeigt ein Ausführungsbeispiel des Schaltgerätes aus Fig. 1 mit einem modularen Aufbau. Gleiche Bezugszeichen bezeichnen dieselben Elemente wie zuvor.

Der Steuerteil 28 ist hier in einem ersten Gehäusemodul 58 angeordnet. Seitlich davon sind eine Vielzahl von weiteren Gehäusemodulen 60 angeordnet. Die Gehäusemodule 58, 60 bilden somit eine Modulreihe. Einige Gehäusemodule 60 beherbergen einen Eingangsteil zur Aufnahme von Eingangssignalen, wie etwa das Modul 26' mit dem Schutztürschalter 16 und das Modul 26‴ mit dem Not-Aus-Schalter 32. Beispielhaft ist in Fig. 2 bei dem Gehäusemodul 26" ferner eine Lichtschranke 62 dargestellt. Jedes der Gehäusemodule 60 besitzt eine Vielzahl von Anschlussklemmen 64, an die die jeweiligen Sensoren/Signalgeber angeschlossen sind. Ein weiteres Gehäusemodul in der Modulreihe beherbergt einen Ausgangsteil 30 mit Anschlussklemmen, an die die Schütze 24a, 24b angeschlossen sind (hier nur zum Teil dargestellt). Mit der Bezugsziffer 66 ist ein elektrischer Antrieb bezeichnet, der bspw. ein Antrieb des Roboters 12 sein kann. Abweichend von der Darstellung in Fig. 1 sind die Schütze 24a, 24b hier noch mit jeweils einem Öffnerkontakt dargestellt, der mit den entsprechenden Schließerkontakten in dem Strompfad zu dem Antrieb 66 zwangsgeführt ist und sich somit synchron zu dem entsprechenden Schließerkontakt bewegt. Ein Strompfad 68 ist von einer Ausgangsklemme des Ausgangsteils 30 über die in Reihe angeordneten Öffnerkontakte der Schütze 24a, 24b zu einem Eingangsanschluss des Ausgangsteils 30 geführt. Der Ausgangsteil 30 kann über den Strompfad 68 den jeweiligen Betriebszustand (geöffnet oder geschlossen) der der Schütze 24a, 24b überwachen und dem Steuerteil 28 als Eingangssignal melden.

Wie in Fig. 2 dargestellt ist, besitzen die Gehäusemodule 60 in diesem Ausführungsbeispiel jeweils einen mit FPGA bezeichneten Schaltkreis. Die FPGA-Schaltkreise beherbergen eine Kommunikationsschnittstelle und bilden einen Kommunikationsbus 70, über den der Steuerteil 28 mit den Eingangsteilen 26', 26", 26‴ und dem Ausgangsteil 30 kommunizieren kann. Die Eingangsteile und Ausgangsteile können ferner jeweils einen Mikrocontroller oder einen anderen Logikschaltkreis aufweisen, der die jeweilige Funktion des Eingangs- oder Ausgangsteils implementiert. Prinzipiell können die FPGA-Schaltkreise auch die Funktion des Mikrocontrollers beinhalten. Es ist außerdem möglich, dass Gehäusemodule 60 sowohl einen Eingangsteil 26 als auch einen Ausgangsteil 30 beinhalten.

In dem Ausführungsbeispiel gemäß Fig. 2 liest der Steuerteil 28 die Eingangssignale von den Sensoren/Signalgebern 16, 32, 62, 68 zyklisch ein und erzeugt in Abhängigkeit davon Steuersignale für die Ausgangsschaltelemente. Die Eingangsteile 26', 26", 26‴ senden daher Daten, die den Eingangssignalen der Sensoren/Signalgeber 16, 32, 62, 68 entsprechen, mit geeigneten Bustelegrammen 72 über den Kommunikationsbus 70 an den Steuerteil 28. Der Steuerteil 28 erzeugt daraus ein Prozessabbild der Eingänge IPI (Input Process Image), das die Zustände aller Sensoren/Signalgeber repräsentiert. In Abhängigkeit von dem IPI erzeugt der Steuerteil 28 ein Prozessabbild der Ausgänge OPI (Output Process Image), das die Steuerbefehle für die Ausgangsschaltelemente repräsentiert. Der Steuerteil 28 überträgt das OPI mit Hilfe von geeigneten Bustelegrammen an den Ausgangsteil 30. Der Ausgangsteil 30 kann die Ausgangsschaltelemente in Abhängigkeit von dem OPI ein- oder ausschalten.

Wie oben schon erläutert, besitzen Ausführungsbeispiele des neuen Schaltgeräts zumindest zwei verschiedene Betriebsmodi. In einem ersten Betriebsmodus werden die Ausgangsschaltelemente 38 bis 46 (siehe Fig. 1) weitgehend synchron zu den Anzeigeelementen 50, 52, 54 geschaltet. Dementsprechend kann ein Anwender den jeweiligen Betriebszustand der Ausgangsschaltelemente anhand der Anzeigeelemente erkennen. In einem alternativen zweiten Betriebsmodus öffnet der Steuerteil 28 hingegen die sicherheitsrelevanten Ausgangsschaltelemente 38 bis 44 unabhängig von den definierten Eingangssignalen der Sensoren/Signalgeber, um auf diese Weise einen Arbeitsbetrieb der Maschinenanlage zu verhindern. Allerdings werden die Anzeigeelemente 50, 52, 54 in dem zweiten aktiven Betriebsmodus weiterhin in Abhängigkeit von den Eingangssignalen ein- oder ausgeschaltet. Die Anzeigeelemente 50, 52 signalisieren in diesem zweiten Betriebsmodus also nicht mehr den tatsächlichen Betriebszustand der Schaltelemente 38 bis 44, sondern einen angenommenen Betriebszustand, den die Schaltelemente 38 bis 44 annehmen würden, wenn sich das Schaltgerät in dem ersten Betriebsmodus befände. Dementsprechend werden die Betriebszustände der Schaltelemente 38 bis 44 in dem zweiten Betriebsmodus simuliert. Die Simulation wird mit Hilfe der Anzeigeelemente 50, 52 sichtbar gemacht und erleichtert es einem Anwender, das Schaltgerät 22 zu konfigurieren.

Die Umschaltung zwischen dem ersten Betriebsmodus und dem zweiten Betriebsmodus kann vorteilhaft mit Hilfe des Betriebsartenwahlschalters 34 erreicht werden. Die Ansteuerung der Anzeigeelemente in dem ersten und zweiten Betriebsmodus kann auf verschiedene Weise realisiert werden.

In einigen Ausführungsbeispielen kann der Steuerteil 28 den jeweils gewählten Betriebsmodus an den Ausgangsteil 30 senden, so dass der Ausgangsteil 30 die Anzeigeelemente in Abhängigkeit von dem gewählten Betriebsmodus synchron oder nicht-synchron zu den Ausgangsschaltelementen schalten kann. Beispielhaft kann die Realisierung somit folgende Verfahrensschritte beinhalten:
1) Der Anwender dreht den Betriebsartenwahlschalter auf die Stellung SIMU.
2) Der Steuerteil sendet an alle Module ein Modus-Telegramm "SIMU-Betrieb".
3) Alle Module merken sich die Betriebsart.
4) Die Module senden eine Rückantwort an den Steuerteil mit der Bestätigung des Betriebsmodus (optional).
5) Der Steuerteil prüft, ob alle Module geantwortet haben (optional).
6) Der Steuerteil starten den zyklischen Betrieb.
7) Der Steuerteil sendet an jedes Modul ein Prozessdaten-Telegramm mit dem OPI.
8) Jedes Modul lässt seine Ausgänge ausgeschaltet. Dies geschieht unabhängig vom Inhalt des OPI.
9) Jedes Modul schaltet seine LEDs gemäß dem OPI.
10) Jedes Modul liest das Ergebnis des Schaltvorganges an seinen Ausgängen.
11) Jedes Modul liest seine Eingänge ein.
12) Jedes Modul sendet eine Prozessdaten-Telegramm-Antwort an den Steuerteil zurück (IPI + OPI).
13) Der Steuerteil prüft, ob er alle Antworten von allen Modulen erhalten hat.
14) Der Steuerteil prüft ob die Ergebnisse (OPIs) seiner Erwartungshaltung entsprechen. Die Erwartungshaltung ist, dass alle Ausgänge ausgeschaltet sind.
15) Der Steuerteil prüft, ob die IPIs plausibel sind.
16) Der Steuerteil berechnet die neuen OPIs und beginnt wieder bei Schritt 7.

Eine solche Realisierung besitzt den Vorteil, dass in jedem der beiden Betriebsmodi eine gleiche Anzahl an Bustelegrammen mit jeweils gleichem Telegrammaufbau verwendet werden kann. Nachteilig ist, dass der jeweils gewählte Betriebsmodus von dem Steuerteil 28 an alle betroffenen Ausgangsteile gesendet werden muss. Zudem muss jeder Ausgangsteil in der Lage sein, die Anzeigeelemente wahlweise synchron oder nicht-synchron zu den Ausgangsschaltelementen zu schalten, was eine gewisse Intelligenz in den Ausgangsteilen erfordert.

In einem alternativen Ausführungsbeispiel kann der Steuerteil 28 daher die Anzeigeelemente ein- oder ausschalten, bspw. mit Hilfe von geeigneten Bustelegrammen, die einen Schaltbefehl für die Anzeigeelemente beinhalten. Ein solches Ausführungsbeispiel kann folgendermaßen realisiert werden:
1) Der Anwender dreht den Betriebsartenwahlschalter auf Stellung SIMU.
2) Der Steuerteil starten den zyklischen Betrieb.
3) Der Steuerteil sendet an jedes Modul ein Prozessdaten-Telegramm, welches die Weisung zum Ausschalten der Ausgänge enthält (OPI = 0).
4) Der Steuerteil sendet an jedes Modul ein LED-Telegramm, welches die LEDs so ein- bzw. ausschaltet wie dies im RUN-Betrieb erfolgen würde.
5) Jedes Modul schaltet seine Ausgänge gemäß dem empfangenen Prozessdaten-Telegramm.
6) Jedes Modul schaltet seine LEDs gemäß dem empfangenen LED-Telegramm.
7) Jedes Modul liest das Ergebnis des Schaltvorganges an seinen Ausgängen.
8) Jedes Modul liest seine Eingänge ein.
9) Jedes Modul sendet eine Prozessdaten-Telegramm-Antwort an den Steuerteil zurück. (IPI+OPI)
10) Der Steuerteil prüft, ob er alle Antworten von allen Modulen erhalten hat.
11) Der Steuerteil prüft, ob die Ergebnisse (OPIs) seiner Erwartungshaltung entsprechen. Die Erwartungshaltung ist, dass alle Ausgänge ausgeschaltet sind.
12) Der Steuerteil prüft, ob die IPIs plausibel sind.
13) Der Steuerteil berechnet die neuen OPIs und beginnt wieder bei Schritt 3).

Diese Realisierung besitzt den Vorteil, dass in dem Ausgangsteil immer der gleiche Verfahrensablauf ausgeführt wird unabhängig davon, in welchem Betriebsmodus sich das Schaltgerät befindet. Der Ausgangsteil benötigt keine Information darüber, ob sich das Schaltgerät in dem ersten oder in dem zweiten Betriebsmodus befindet. nahteilig ist, dass zusätzliche Bustelegrammen für das Ein- und Ausschalten der Anzeigeelemente benötigt werden. In dem Steuerteil können sich abhängig von dem gewählten Betriebsmodus unterschiedliche Verarbeitungszeiten ergeben.

In weiteren Ausführungsbeispielen versendet der Steuerteil 28 in Abhängigkeit von dem gewählten Betriebsmodus ein Bustelegramm mit einer Bitmaske an alle Ausgangsteile 30. Die Bitmaske enthält einen Maskenwert, der in dem Ausgangsteil 30 mit dem OPI verknüpft wird, um maskierte Steuerbefehle für die Ausgangsschaltelemente 38 bis 44 zu erzeugen. Vereinfacht ist in Fig. 3 ein Bustelegramm 72 und eine Bitmaske 74 dargestellt. Das Bustelegramm 72 beinhaltet eine Zieladresse 76, die den Ausgangsteil 30 innerhalb der Modulreihe identifiziert. Das Bustelegramm 72 enthält ferner das OPI 78 und optionale weitere Telegrammbestandteile, wie etwa eine CRC (Cycle Redundancy Check) zur Erkennung von Übertragungsfehlern. In dem Ausgangsteil 30 kann die Bitmaske 74 mit dem OPI UND-verknüpft werden, um ein neues OPI zu bestimmen, mit dem die Ausgangsschaltelemente angesteuert werden. In bevorzugten Ausführungsbeispielen eines Sicherheitsschaltgerätes ist die UND-Verknüpfung zweikanalig realisiert. Beispielsweise kann die Bitmaske 74 in dem ersten Betriebsmodus für jedes Ausgangsschaltelement eine "1" enthalten, während die Bitmaske 74 in dem zweiten Betriebsmodus für jedes Ausgangsschaltelement eine "0" enthält. Dementsprechend kann die Implementierung folgende Schritte beinhalten:
1) Der Anwender dreht den Betriebsartenwahlschalter auf Stellung SIMU.
2) Der Steuerteil sendet an alle Module ein Masken-Telegramm mit der Bitmaske=00.
3) Der Steuerteil startet den zyklischen Betrieb.
4) Der Steuerteil sendet an jedes Modul ein Prozessdaten-Telegramm (OPI).
5) Jedes Modul schaltet seine LEDs gemäß dem OPI in dem Prozessdaten-Telegramm.
6) Jedes Modul verknüpft das empfangene OPI mit der Bitmaske und erhält so das "neue OPI".
7) Jedes Modul schaltet seine Ausgänge gemäß dem "neuen OPI".
8) Jedes Modul liest das Ergebnis des Schaltvorganges an seinen Ausgängen.
9) Jedes Modul liest seine Eingänge ein.
10) Jedes Modul sendet eine Prozessdaten-Telegramm-Antwort an den Steuerteil zurück. (IPI+OPI)
11) Der Steuerteil prüft, ob er alle Antworten von allen Modulen erhalten hat.
12) Der Steuerteil verknüpft seine Erwartungshaltung mit der Maske und erhält so die "neue Erwartungshaltung".
13) Der Steuerteil prüft, ob die Ergebnisse (OPIs) der "neuen Erwartungshaltung" entsprechen.
14) Der Steuerteil prüft ob die IPIs plausibel sind.
15) Der Steuerteil berechnet die neuen OPIs und beginnt wieder bei Schritt 4).

Ein Nachteil dieser Realisierung ist, dass die Bitmaske 74 zusätzlich zu dem OPI an den Ausgangsteil 30 übertragen werden muss, was ein zusätzliches oder längeres Bustelegramm 72 erfordert. Der Vorteil dieser Realisierung ist demgegenüber, dass der Verfahrensablauf unabhängig von dem gewählten Betriebsmodus im Steuerteil und im Ausgangsteil gleich sein kann. Insbesondere können identische Softwarecodes unabhängig von der jeweils gewählten Betriebsart ausgeführt.

In allen bevorzugten Ausführungsbeispielen wird ein nicht-sicherheitsrelevantes Ausgangsschaltelement 46 sowohl in dem ersten Betriebsmodus als auch in dem zweiten Betriebsmodus in Abhängigkeit von den definierten Eingangssignalen angesteuert, während die sicherheitsrelevanten Ausgangsschaltelemente 38 bis 44 nur in dem ersten Betriebsmodus in Abhängigkeit von den definierten Eingangssignalen angesteuert werden und in dem zweiten Betriebsmodus geöffnet sind.

## Patentansprüche

1. Schaltgerät zum gezielten Einschalten und/oder Ausschalten eines elektrischen Verbrauchers (24a, 24b) mit einem Eingangsteil (26) zum Aufnehmen eines definierten Eingangssignals (20), mit einem Ausgangsteil (30), der einen Strompfad mit einem Ausgangsschaltelement (38, 40, 42, 44) zu dem elektrischen Verbraucher (24a, 24b) aufweist, wobei das Ausgangsschaltelement (38, 40, 42, 44) einen geschlossenen Betriebszustand oder einen geöffneten Betriebszustand annehmen kann, mit einem Steuerteil (28), der einen ersten aktiven Betriebsmodus und einen zweiten aktiven Betriebsmodus besitzt, wobei der Steuerteil (28) in dem ersten aktiven Betriebsmodus das Ausgangsschaltelement (38, 40, 42, 44) in Abhängigkeit von dem definierten Eingangssignal (20) ansteuert, um den Strompfad in Abhängigkeit von dem definierten Eingangssignal (20) zu schließen oder zu unterbrechen, und mit einem Anzeigeelement (50, 52), das einen ersten Anzeigezustand und einen alternativen zweiten Anzeigezustand annehmen kann, **dadurch gekennzeichnet,**
**dass** das Anzeigeelement (50, 52) den ersten Anzeigezustand annimmt, wenn der Steuerteil (28) in dem ersten aktiven Betriebsmodus ist und das Ausgangsschaltelement (38, 40, 42, 44) in dem geschlossenen Betriebszustand ist,
**dass** das Anzeigeelement (50, 52) den alternativen zweiten Anzeigezustand annimmt, wenn der Steuerteil (28) in dem ersten aktiven Betriebsmodus ist und das Ausgangsschaltelement (38, 40, 42, 44) in dem geöffneten Betriebszustand ist,
**dass** das Ausgangsschaltelement (38, 40, 42 44) den Strompfad in dem zweiten aktiven Betriebsmodus des Steuerteils (28) unabhängig von dem definierten Eingangssignal (20) unterbricht, und
**dass** das Anzeigeelement (50, 52) in Abhängigkeit von dem definierten Eingangssignal (20) den ersten Anzeigezustand oder den alternativen zweiten Anzeigezustand annimmt, wenn der Steuerteil (28) in dem zweiten aktiven Betriebsmodus ist.

2. Schaltgerät nach Anspruch 1, **dadurch gekennzeichnet, dass** der Ausgangsteil (30) einen weiteren Strompfad mit einem weiteren Ausgangsschaltelement (46) aufweist, das der Steuerteil (28) in dem ersten aktiven Betriebsmodus und in dem zweiten aktiven Betriebsmodus in Abhängigkeit von dem definierten Eingangssignal (20) ansteuert.

3. Schaltgerät nach Anspruch 1 oder 2, **gekennzeichnet durch** einen Betriebsmoduswahleingang zum Zuführen eines Betriebsmoduswahlsignals (34), mit dem der Steuerteil (28) wahlweise in den ersten oder in den zweiten Betriebsmodus versetzt werden kann.

4. Schaltgerät nach einem der Ansprüche 1 bis 3, **dadurch gekennzeichnet, dass** der Steuerteil (28) das Anzeigeelement (50, 52) in dem zweiten aktiven Betriebsmodus ansteuert.

5. Schaltgerät nach einem der Ansprüche 1 bis 4, **dadurch gekennzeichnet, dass** der Ausgangsteil (30) das Anzeigeelement (50, 52) in dem ersten aktiven Betriebsmodus ansteuert.

6. Schaltgerät nach einem der Ansprüche 1 bis 5, **gekennzeichnet durch** eine Vielzahl von Gehäusemodulen (58, 60), die wahlweise aneinandergefügt oder voneinander gelöst werden können, wobei ein erstes Gehäusemodul (58) den Steuerteil (28) beherbergt, und wobei ein zweites Gehäusemodul (60) den Ausgangsteil (30) beherbergt.

7. Schaltgerät nach einem der Ansprüche 1 bis 6, **gekennzeichnet durch** einen Kommunikationsbus (70), der den Steuerteil (28) und den Ausgangsteil (30) kommunikativ verbindet.

8. Schaltgerät nach einem der Ansprüche 1 bis 7, **dadurch gekennzeichnet, dass** der Ausgangsteil (30) einen Rückleseschaltkreis (48) aufweist, der ein aktuelles Betriebszustandssignal erzeugt, das für den geöffneten und/oder den geschlossenen Betriebszustand des Ausgangsschaltelements (38, 40, 42, 44) repräsentativ ist, wobei der Steuerteil (28) das Ausgangsschaltelement (38, 40, 42, 44) in Abhängigkeit von dem Betriebszustandssignal ansteuert.

9. Schaltgerät nach einem der Ansprüche 1 bis 8, **gekennzeichnet durch** einen Speicher, in dem eine Bitmaske (74) gespeichert ist, die den jeweils aktiven Betriebsmodus repräsentiert, wobei das Ausgangsschaltelement (38, 40, 42, 44) in Abhängigkeit von der Bitmaske (74) gesteuert ist.

## Claims

1. A switching device for selectively switching on and/or switching off an electrical load (24a, 24b), comprising an input section (26) for receiving a defined input signal (20), comprising an output section (30) that has a current path having an output switching element (38, 40, 42, 44) to the electrical load (24a, 24b), wherein the output switching element (38, 40, 42, 44) can assume a closed operating state or an open operating state, comprising a control section (28) that has a first active mode of operation and a second active mode of operation, wherein the control section (28) actuates the output switching element (38, 40, 42, 44) in the first active mode of operation on the basis of the defined input signal (20) in order to complete or interrupt the current path on the basis of the defined input signal (20), and comprising a display element (50, 52) that can assume a first display state and an alternative second display state, **characterized in**
**that** the display element (50, 52) assumes the first display state when the control section (28) is in the first active mode of operation and the output switching element (38, 40, 42, 44) is in the closed operating state,
**that** the display element (50, 52) assumes the alternative second display state when the control section (28) is in the first active mode of operation and the output switching element (38, 40, 42, 44) is in the open operating state,
**that** the output switching element (38, 40, 42, 44) interrupts the current path regardless of the defined input signal (20) in the second active mode of operation of the control section (28), and
**that** the display element (50, 52) assumes the first display state or the alternative second display state on the basis of the defined input signal (20) when the control section (28) is in the second active mode of operation.

2. The switching device according to Claim 1, **characterized in that** the output section (30) has a further current path having a further output switching element (46) that the control section (28) actuates on the basis of the defined input signal (20) both in the first active mode of operation and in the second active mode of operation.

3. The switching device according to Claim 1 or 2, **characterized by** a mode-of-operation selection input for supplying a mode-of-operation selection signal (34) by means of which the control section (28) can selectively be put either into the first mode of operation or into the second mode of operation.

4. The switching device according to one of Claims 1 to 3, **characterized in that** the control section (28) actuates the display element (50, 52) in the second active mode of operation.

5. The switching device according to one of Claims 1 to 4, **characterized in that** the output section (30) actuates the display element (50, 52) in the first active mode of operation.

6. The switching device according to one of Claims 1 to 5, **characterized by** a plurality of housing modules (58, 60) that can be either combined or detached from one another, wherein a first housing module (58) accommodates the control section (28), and wherein a second housing module (60) accommodates the output section (30).

7. The switching device according to one of Claims 1 to 6, **characterized by** a communication bus (70) that communicatively connects the control section (28) and the output section (30).

8. The switching device according to one of Claims 1 to 7, **characterized in that** the output section (30) has a read-back circuit (48) that generates a instantaneous operating state signal that is representative of the open operating state and/or the closed operating state of the output switching element (38, 40, 42, 44), wherein the control section (28) actuates the output switching element (38, 40, 42, 44) on the basis of the operating state signal.

9. The switching device according to one of Claims 1 to 8, **characterized by** a memory storing a bit mask (74) that represents the respectively active mode of operation, wherein the output switching element (38, 40, 42, 44) is controlled on the basis of the bit mask (74).

## Revendications

1. Appareil de commutation destiné à la mise sous et/ou hors tension ciblée d'un consommateur électrique (24a, 24b), comprenant une partie d'entrée (26) destinée à enregistrer un signal d'entrée défini (20), une partie de sortie (30) qui présente un trajet de courant comprenant un élément de commutation de sortie (38, 40, 42, 44) vers le consommateur électrique (24a, 24b), l'élément de commutation de sortie (38, 40, 42, 44) pouvant adopter un état de fonctionnement fermé ou un état de fonctionnement ouvert, une partie de commande (28) qui dispose d'un premier mode de fonctionnement actif et d'un deuxième mode de fonctionnement actif, la partie de commande (28) dans le premier mode de fonctionnement pilotant l'élément de commutation de sortie (38, 40, 42, 44) en fonction du signal d'entrée défini (20) afin de fermer ou d'interrompre le trajet de courant en fonction du signal d'entrée défini (20), et un élément d'affichage (50, 52) qui peut adopter un premier état d'affichage et un deuxième état d'affichage alternatif,
**caractérisé**
**en ce que** l'élément d'affichage (50, 52) adopte le premier état d'affichage si la partie de commande (28) se trouve dans le premier mode de fonctionnement actif, et l'élément de commutation de sortie (38, 40, 42, 44) se trouve à l'état de fonctionnement fermé,
**en ce que** l'élément d'affichage (50, 52) adopte le deuxième état d'affichage alternatif si la partie de commande (28) se trouve dans le premier mode de fonctionnement actif et l'élément de commutation de sortie (38, 40, 42, 44) se trouve à l'état de fonctionnement ouvert,
**en ce que** l'élément de commutation de sortie (38, 40, 42 44) interrompt le trajet de courant dans le deuxième mode de fonctionnement actif de la partie de commande (28) indépendamment du signal d'entrée défini (20), et
**en ce que** l'élément d'affichage (50, 52) adopte en fonction du signal d'entrée défini (20) le premier état d'affichage ou le deuxième état d'affichage alternatif si la partie de commande (28) se trouve dans le deuxième mode de fonctionnement actif.

2. Appareil de commutation selon la revendication 1, **caractérisé en ce que** la partie de sortie (30) présente un trajet de courant supplémentaire avec un élément de commutation de sortie supplémentaire (46) qui pilote la partie de commande (28) dans le premier mode de fonctionnement actif et dans le deuxième mode de fonctionnement actif en fonction du signal d'entrée défini (20).

3. Appareil de commutation selon la revendication 1 ou 2, **caractérisé par** une entrée de sélection de mode de fonctionnement destinée à acheminer un signal de sélection de mode de fonctionnement (34) qui permet de mettre la partie de commande (28) sélectivement dans le premier ou dans le deuxième mode de fonctionnement.

4. Appareil de commutation selon l'une quelconque des revendications 1 à 3, **caractérisé en ce que** la partie de commande (28) pilote l'élément d'affichage (50, 52) dans le deuxième mode de fonctionnement actif.

5. Appareil de commutation selon l'une quelconque des revendications 1 à 4, **caractérisé en ce que** la partie de sortie (30) pilote l'élément d'affichage (50, 52) dans le premier mode de fonctionnement actif.

6. Appareil de commutation selon l'une quelconque des revendications 1 à 5, **caractérisé par** une pluralité de modules de boîtier (58, 60) qui peuvent être sélectivement assemblés ou séparés, un premier module de boîtier (58) logeant la partie de commande (28) , et un deuxième module de boîtier (60) logeant la partie de sortie (30).

7. Appareil de commutation selon l'une quelconque des revendications 1 à 6, **caractérisé par** un bus de communication (70) qui relie la partie de commande (28) et la partie de sortie (30) en communication.

8. Appareil de commutation selon l'une quelconque des revendications 1 à 7, **caractérisé en ce que** la partie de sortie (30) présente un circuit de relecture (48) qui produit un signal d'état de fonctionnement actuel qui est représentatif de l'état de fonctionnement ouvert et/ou fermé de l'élément de commutation de sortie (38, 40, 42, 44), la partie de commande (28) pilotant l'élément de commutation de sortie (38, 40, 42, 44) en fonction du signal d'état de fonctionnement.

9. Appareil de commutation selon l'une quelconque des revendications 1 à 8, **caractérisé par** une mémoire dans laquelle est stocké un masque de bits (74) qui représente le mode de fonctionnement respectivement actif, l'élément de commutation de sortie (38, 40, 42, 44) étant commandé en fonction du masque de bits (74).
